# EUROPEAN PATENT SPECIFICATION

(11) **EP 0 409 173 B1**
(45) Date of publication and mention of the grant of the patent: **12.10.1994**
(21) Application number: 90113690.3
(22) Date of filing: 17.07.1990
(51) Int. Cl.: H01L 23/492, H01L 23/495, H01L 23/50

(54) **Semiconductor ic device having an improved interconnection structure**
Halbleiter-IC-Bauelement mit verbesserter Interkonnektionsstruktur
Dispositif à circuit intégré semi-conducteur ayant une structure d'interconnexion améliorée

(30) Priority: 19.07.1989 JP 186600/89
(43) Date of publication of application: 23.01.1991
(73) Proprietor: NEC CORPORATION, Tokyo (JP)
(72) Inventor: Ishioka, Hiroshi, C/o NEC Corporation, Tokyo (JP)
(74) Representative: Glawe, Delfs, Moll & Partner

(56) References cited:
- EP-A- 0 180 219
- EP-A- 0 198 194
- EP-A- 0 299 252
- EP-A- 0 405 871

## Description

The present invention relates to a semiconductor IC device in which an LOC (Lead On Chip) type lead frame bonded to a semiconductor pellet is electrically connected to the semiconductor pellet through bonding wires.

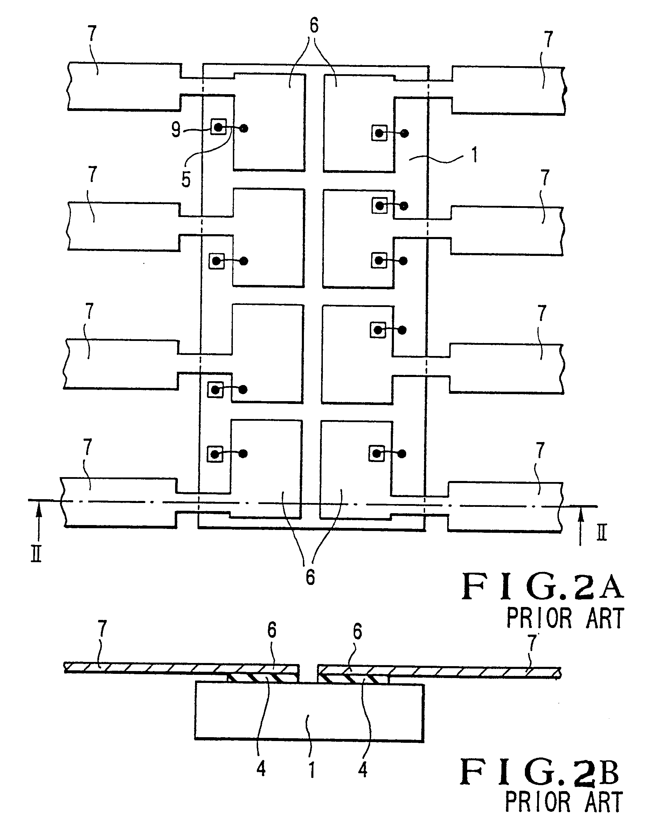

Figs. 2A und 2B show a semiconductor IC device including a conventional LOC type lead frame, which is known from EP-A-0 198 194.

The conventional LOC type lead frame includes leads 7 and connecting terminals 6 constituted by conductive plates and connected to the leads 7. An insulating film 4 is formed on portions of a semiconductor pellet 1 which correspond to the connecting terminals 6.

The LOC type lead frame is fixed on the major surface of the semiconductor pellet 1, on which active elements are formed, e.g. by an adhesive agent. Electrodes 9 formed on a peripheral portion of the major surface of the semiconductor pellet 1 are electrically connected to the connecting terminals 6 through bonding wires 5.

The semiconductor IC device including the conventional LOC type lead frame, however, has the following drawback. Since the connecting terminals 6 are arranged on the major surface of the semiconductor pellet 1, at which surface the active elements are formed, through the insulating film 4, the connecting terminals 6 are located close to the internal circuit formed in the semiconductor pellet 1. For this reason, if a vertical electric field is generated by the connecting terminals 6 due to voltages, such as input/output signals, externally applied to the leads 7, this electric field enters the internal circuit of the semiconductor pellet 1. Since the active elements formed at the surface of the semiconductor pellet 1 are operated by signals of low potentials, various kinds of inconvenience may be caused, e.g., the internal circuit of the semiconductor pellet 1 is influenced by the electric field, and the operation margin of the semiconductor IC device is reduced.

EP-A-0 405 871 which is a document under article 54(3) EPC shows a semiconductor IC device comprising a semiconductor pellet, on a major surface of which a plurality of electrodes and a plurality of active elements are formed. To the major surface of the pellet a first insulating film is bonded covering the active elements and leaving access to the electrodes. On this first insulating film a conductive plate is arranged and a lead frame including a plurality of connecting terminals selectively arranged in predetermined regions is mounted on said conductive plate through a second insulating film, wherein leads are integral with and laterally extending from the connecting terminals. Each connecting terminal is connected to a corresponding electrode on the pellet by a bonding wire.

It is an object of the present invention to provide a semiconductor IC device including an LOC type lead frame which can prevent an electric field from influencing a semiconductor pellet.

In order to achieve the above object according to the present invention, there is provided a semiconductor IC device as defined in the claim.

With this arrangement, an electric field generated by the connecting terminals is blocked by the conductive plate and hence cannot enter the semiconductor pellet. Therefore, predetermined characteristics of the internal circuit of the semiconductor pellet are maintained, and inconvenience such as operations errors can be prevented. As the conductive plate additionally can be used as wiring for the power source or ground potential, the degree of freedom of the layout of the semiconductor pellet is greatly increased.
Fig. 1A is a plan view showing a semiconductor IC device including an LOC type lead frame according to one embodiment of the present invention;
Fig. 1B is a sectional view taken along a line IB - IB in Fig. 1A;
Fig. 1C is a sectional view taken along a line IC - IC in Fig. 1A;
Fig. 2A is a plan view showing a conventional LOC type lead frame for a semiconductor IC device; and
Fig. 2B is a sectional view taken along a line II - II in Fig. 2A.

Embodiments of the present invention will be described below with reference to the accompanying drawings.

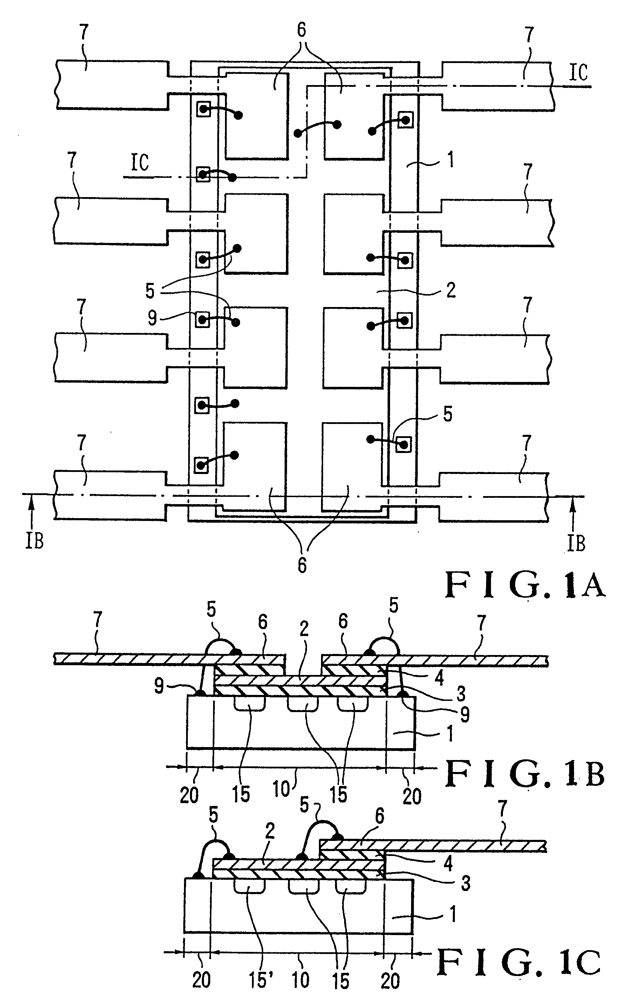

Figs. 1A, 1B and 1C show a semiconductor IC device including an LOC type lead frame according to one embodiment of the present invention.

In this embodiment, a conductive plate 2 is bonded through a first insulating film 3 of polyimide material to a surface of a central portion 10 of a semiconductor pellet 1 at which surface active elements 15 including an internal circuit 15′ are formed.

The conductive plate 2 is rectangular and has a size large enough to cover the surface of the semiconductor pellet 1 except for its peripheral portion 20. Connecting terminals 6 are bonded to predetermined regions on the conductive plate 2 through a second insulating film 4 of polyimide material. The conductive plate 2 is made of 42 alloy metal (Ni - Fe alloy) or copper alloy as that for the leads 7, and has substantially the same planar shape as that of the pellet 1 except for the peripheral portion 20, to cover all active elements 15. The conductive plate 2 has the same thickness as that of the leads 7. The respective connecting terminals 6 are integrally formed with leads 7. The leads 7 laterally extend from the semiconductor pellet 1. Electrodes 9 are formed on the peripheral portion 20 of the semiconductor pellet 1, which is not covered with the conductive plate 2. These electrodes 9 and the connecting terminals 6 are connected by bonding wires 5 (Fig. 1B).

As far as decribed above, since the conductive plate 2 is arranged between the connecting terminals 6 and semiconductor pellet 1, an electric field generated by the connecting terminals 6 is blocked by the conductive plate 2 and does not enter the semiconductor pellet 1. This can prevent inconveniences such as operating errors of the semiconductor device and a reduction in operating margin.

As mentioned above, after the lead frame is bonded to the semiconductor pellet 1, the pellet 1 is connected to the connecting terminals 6 through bonding wires 5. This is done in the following manner:

As shown in Fig. 1B, the connecting terminals 6 are connected to electrodes such as signal lines, which are formed on the semiconductor pellet 1, through bonding wires 5.

As shown in Fig. 1C, a predetermined connecting terminal 6 to be connected to one of the power source or ground, and the conductive plate 2 are connected to each other through a bonding wire 5. As a result, the conductive plate 2 is set at the power source or ground potential.

Subsequently, an electrode formed on the semiconductor pellet 1 which is to be connected to the power source or ground is connected to the conductive plate 2 through a bonding wire 5.

Since the conductive plate 2 is connected to the power source or ground in this manner, the power source electrode or the ground electrode formed on the semiconductor pellet 1 can be easily connected.

As it has been described above, according to the present invention, the conductive plate set at the power source or ground potential is arranged between the connecting terminals and the semiconductor pellet.

This arrangement can prevent an electric field as noise generated by the connecting terminals due to input/output signals from locally influencing the internal circuit of the semiconductor pellet. In addition the conductive plate is used as the wiring for the power source or ground potential. This greatly increases the degree of freedom in terms of the layout of a semiconductor pellet.

## Claims

1. A semiconductor IC device comprising
a semiconductor pellet (1) at a surface of which a plurality of electrodes (9) and a plurality of active elements (15) are formed;
an insulating film (3) bonded to that part of said surface of the semiconductor pellet (1) on which the active elements (15) are formed and leaving access to the electrodes (9) for conductive wires (5);
a conductive plate (2) arranged on said insulating film (3) and covering the active elements (15);
a lead frame including a plurality of connecting terminals (6) selectively arranged in predetermined regions on said conductive plate (2) through another insulating film (4) wherein the connecting terminals (6) are integrally formed with leads (7) extending laterally therefrom;
said electrodes (9) being respectively connected by conductive wires (5) to said connecting terminals (6), whereby one of said electrodes (9) is connected by one of said wires (5) to said conductive plate (2) which in turn is connected by a conductive wire (5) to one of said connecting terminals (6) which is connected to a power source or ground.

## Patentansprüche

1. Halbleiter-IC-Vorrichtung mit
einem Halbleitersubstrat (1), auf dessen Oberfläche eine Anzahl von Elektroden (9) und eine Anzahl aktiver Elemente (15) ausgebildet sind,
einem Isolierfilm (3), der an dem Teil der Oberfläche des Halbleitersubstrats (1) befestigt ist, auf dem die aktiven Elemente (15) ausgebildet sind und der Zugriff zu den Elektroden (9) für leitende Verdrahtungen (5) freiläßt,
einer leitenden Platte (2), die auf dem Isolierfilm (3) angeordnet ist und die aktiven Elemente (15) abdeckt,
einem Zuleitungsrahmen mit einer Anzahl Verbindungsanschlüsse (6), die selektiv in vorgegebenen Bereichen auf der leitenden Platte (2) über einen weiteren Isolierfilm (4) angeordnet sind, wobei die Verbindungsanschlüsse (6) einstückig mit Zuleitungen (7), die sich davon seitlich erstrecken, ausgebildet sind,
wobei die Elektroden (9) jeweils mit leitenden Verdrahtungen (5) zu den Verbindungsanschlüssen (6) verbunden sind, wodurch eine der Elektroden (9) durch eine der Verdrahtungen (5) mit der leitenden Platte (2) verbunden ist, die ihrerseits durch eine leitende Verdrahtung (5) mit einem der Verbindungsanschlüsse (6) verbunden ist, der mit einer Spannungsquelle oder mit Masse verbunden ist.

## Revendications

1. Dispositif CI à semi-conducteur comprenant :
une pastille de semi-conducteur (1) à la surface de laquelle une multitude d'électrodes (9) et une multitude d'éléments actifs (15) sont formés,
un film isolant (3) lié à la partie de ladite surface de la pastille de semi-conducteur (1) sur laquelle les éléments actifs (15) sont formés et laissant accès aux électrodes (9) pour des fils conducteurs (5);
une plaque conductrice (2) disposée sur ledit film isolant (3) et recouvrant les éléments actifs (15);
un cadre de montage de comportant une multitude de bornes de connexion (6) disposées sélectivement dans des zones prédéterminées sur ladite plaque conductrice (2) par l'intermédiaire d'un autre film isolant (4),
où les bornes de connexion (6) sont formées en une pièce avec des fils (7) s'étendant latéralement à partir d'elles;
lesdites électrodes (9) étant reliées respectivement par des fils conducteurs (5) auxdites bornes de connexion (6), d'où il résulte que l'une desdites électrodes (9) est reliée par l'un desdits fils (5) à ladite plaque conductrice (2), laquelle est à son tour connectée par un fil conducteur (5) à l'une desdites bornes de connexion (6) qui est reliée à une source d'alimentation ou à la masse.
